# EUROPÄISCHE PATENTSCHRIFT

(11) **EP 1 847 163 B1**
(45) Veröffentlichungstag und Bekanntmachung des Hinweises auf die Patenterteilung: **12.03.2008**
(21) Anmeldenummer: 06706170.5
(22) Anmeldetag: 05.01.2006
(51) Int. Cl.: H05K 5/02, H02B 1/56

(54) **SCHALTSCHRANK**
SWITCH CABINET
ARMOIRE DE COMMANDE

(30) Priorität: 07.02.2005 DE 102005005588
(43) Veröffentlichungstag der Anmeldung: 24.10.2007
(73) Patentinhaber: Knürr AG, 94424 Arnstorf (DE)
(72) Erfinder: TREPTE, Wolfgang, 01665 Zehren (DE); EBERMANN, Heiko, 01109 Dresden (DE)
(74) Vertreter: Heim, Hans-Karl
(86) Internationale Anmeldenummer: PCT/EP2006/000063
(87) Internationale Veröffentlichungsnummer: WO 2006/081909

(56) Entgegenhaltungen:
- EP-A- 0 345 190
- WO-A-01/63713
- DE-A1- 19 817 247
- US-A- 5 974 815

## Beschreibung

Die Erfindung betrifft einen Schaltschrank gemäß dem Oberbegriff des Anspruchs 1.

Die Erfindung ist auch für Geräte- und Netzwerkschränke geeignet, bei denen ein Kühlluftstrom im Kreislauf geführt und mit Hilfe eines Kühlgerätes gekühlt wird. Bevorzugtes Anwendungsgebiet sind Serverschränke.

Aus 20 2004 006 552.5 ist ein Kühlungssystem für Geräte- und Netzwerkschränke bekannt. In einem abgedichteten Innenraum sind elektronische Moduleinheiten, beispielsweise Server, angeordnet, und ein geschlossener Kühlluftkreislauf weist einen Luft-Wasser-Wärmetauscher zur Abkühlung der mit der Verlustwärme der elektronischen Moduleinheiten beaufschlagten Abluft auf. Der Luft-Wasser-Wärmetauscher ist in einem unteren Bereich des Schrankes angeordnet, und es ist eine Luftführung mit gleichlangen Luftwegen und damit gleichen Luftwiderständen für die einzelnen Moduleinheiten realisiert, so dass den einzelnen Moduleinheiten kalte Zuluft mit einer nahezu einheitlichen Zulufttemperatur zugeführt wird.

Zur Abführung der erheblichen Verlustleistungen von Hochleistungsprozessoren und Servern des Schrankes und unter Berücksichtigung, dass in der Regel eine relativ große Anzahl derartiger Schränke in einem Raum aufgestellt sind, ist der Luft-Wasser-Wärmetauscher an die Kaltwasserversorgung des Gebäudes angeschlossen. Dadurch kann die gesamte Verlustleistung der Schränke durch das Kaltwassersystem des Gebäudes abgeführt und ein Wärmeübergang zwischen dem Aufstellungsraum und den Schränken außerordentlich kostensparend vermieden werden.

Da Schaltschränke in aller Regel eine luftdichte Konstruktion aufweisen, ist ein Luftaustausch zwischen dem Schrankinnenraum und dem Aufstellungsraum verhindert. Innerhalb des Wärmetauschers kann es dann zu örtlichen Taupunktunterschreitungen kommen, und bei Verwendung von Kühlwasser mit einer Temperatur unter 12°C und/oder einer hohen Luftfeuchtigkeit im Aufstellungsraum kommt es zu einer Kondensatbildung innerhalb des Wärmetauschers. Damit verbunden ist eine Absenkung der absoluten Luftfeuchtigkeit innerhalb des Schaltschrankes, was zu Schäden an den eingebauten Moduleinheiten und Systemen führen kann.

Es wurde bereits vorgeschlagen (DE 10 2004 049 487.8), die Luftfeuchte innerhalb des Schrankes bzw. des Kühlluftstromes durch eine definierte Zuführung von Außenluft stabil zu halten. In Abhängigkeit von den Umgebungsbedingungen und den Zielwerten im Schrank werden Undichtigkeiten bzw. Unterbrechungen im Schrankgehäuse ausgebildet, welche eine definierte Außenluftzuführung in das Schrankinnere, insbesondere im Bereich der Ansaugseite eines Lüfters, gewährleisten. Durch eine derartige Luftfeuchtestabilisierung werden die Nachteile einer Kondensatbildung und Entfeuchtung unterhalb eines vorgegebenen Wertes, insbesondere Schäden an den Geräten und Systemen im Schrankinneren, vermieden. Es sind jedoch Einrichtungen erforderlich, um das gebildete Kondenswasser abzuführen.

Aus DE 298 23 784 U1 ist ein Kühlgerät für einen Schaltschrank mit einer Kondensatabführeinheit bekannt. Das Kondensat wird in einem Kondensatsammler gesammelt, und bei Erreichen einer vorgebbaren Füllstandshöhe wird eine Detektoreinrichtung mit einem Schwimmerschalter aktiviert. Über einen Ablauf in der Kondensatwanne und eine Ableitung wird das Kondensat aus dem Kühlgerät und Schaltschrank abgeführt.

In WO 01/63713 A1 ist ein Schaltschrank mit einer Klimatisierungseinrichtung beschrieben, welche ein Kältekreislaufsystem mit einem Verdampfer und einem Verflüssiger aufweist. Der Verdampfer ist zusammen mit einem Lüfter in einer Verdampfereinheit integriert und am Schaltschrank angeordnet, während der Verflüssiger mit einem Lüfter in eine Verflüssigereinheit integriert und räumlich getrennt von der Verdampfereinheit und vom Schaltschrank, insbesondere außerhalb des Aufstellungsraums des Schaltschrankes, angeordnet wird. Dadurch soll die Wärmeeinbringung und der Geräuschpegel im Aufstellungsraum des Schaltschrankes reduziert und eine verbesserte Kühlung des Schrankinnenraumes und der darin angeordneten Bauteile erreicht werden. Die Verdampfereinheit weist einen Kondensatauffang und eine Kondensatverdunstungseinrichtung auf, und das am Verdampfer anfallende Kondensat wird verdunstet und mit Hilfe eines Lüfters nach außen abgeführt.

Bei dem in DE 198 17 247 A1 beschriebenen Kühlgerät sollen die Einrichtungen zum Ableiten des Kondenswasser in die Umgebung des Schaltschrankes dadurch vermieden werden, dass das Kondenswasser, welches in einer Sammeleinrichtung unterhalb des Kühlgerätes gesammelt wird, mit Hilfe eines Auffangbehälters und eines darin angeordneten Heizelementes verdunstet wird.

Der entstehende Wasserdampf soll über die Luftströmung im Kühlgerät abtransportiert werden, und zu einer möglichen Entfeuchtung des Kühlluftstromes ist nichts ausgesagt. Die bekannte Kondenswasserverdunstung ist mit einer Zuführung von Wärmeenergie verbunden, wodurch eine erhöhte Kühlleistung des Luft-Wärme-Tauschers erforderlich ist.

Der Erfindung liegt die **Aufgabe** zugrunde, einen Schaltschrank mit einem Wärmetauscher zu schaffen, welcher unter Vermeidung einer Kondensatabführung in die Umgebung eine außerordentlich effiziente Kühlung und Luftfeuchtestabilisierung im Schaltschrank gewährleistet.

Erfindungsgemäß wird die Aufgabe durch die Merkmale des Anspruchs 1 gelöst. Vorteilhafte und zweckmäßige Ausgestaltungen sind in den Unteransprüchen und in der Figurenbeschreibung enthalten.

Ein Grundgedanke der Erfindung kann darin gesehen werden, in einem Wärmetauscher anfallendes Kondensat in einer Sammeleinrichtung zu sammeln und mit Hilfe einer Zerstäubereinrichtung, welche im Schaltschrank, bezogen auf die Strömungsrichtung der in einem geschlossenen Kreislauf geführten Luft, vor dem Wärmetauscher angeordnet ist, in Aerosole zu überführen, welche sofort wieder der im Kreislauf geführten Kühlluft zugeführt werden.

Indem das anfallende Kondensat, zumindest in einer vorgebbaren Menge, zu einem ultrafeinen Nebel, insbesondere mit einer Aerosolgröße < 0,001 mm, zerstäubt wird, wird eine Ableitung nach außerhalb des Schaltschrankes nicht erforderlich. Gleichzeitig wird eine weitgehend stabile Luftfeuchtigkeit im Schaltschrank gewährleistet, da das gebildete Kondensat der Zerstäubungseinrichtung zugeführt, in Kondenswasseraerosole zerstäubt und umgehend dem Kühlluftstrom wieder zugeführt wird.

Erfindungsgemäß ist die Zerstäubungseinrichtung, bezogen auf die Strömungsrichtung des Kühlluftstroms, vor dem Wärmetauscher angeordnet. Die Kondenswasseraerosole gelangen dann in den mit der Verlustwärme der elektronischen Moduleinheiten beladenen, warmen und trockenen Abluftstrom. Bedingt durch die hohe spezifische Oberfläche werden die Kondenswasseraerosole sofort von diesem warmen und trockenen Abluftstrom aufgenommen und verdunsten. Durch die Verdunstung kommt es zu einer adiabaten Abkühlung des Luftstromes. Bei der nachfolgenden Kühlung des Abluftstromes im Wärmetauscher wird somit weniger Energie benötigt.

Es ist von Vorteil, als Zerstäubungseinrichtung einen oder mehrere Ultraschallschwinger bzw. Ultraschallzerstäuber anzuordnen, welche keine Wärmeentwicklung zeigen und sich durch eine geringe Baugröße, drucklose Zerstäubung und einen geringen Energiebedarf auszeichnen.

Besonders vorteilhaft ist die Verwendung von Ultraschallschwingern, deren Zerstäuberleistung variierbar ist, wodurch eine vorgebbare Luftfeuchte im Schaltschrank gewährleistet werden kann.

Zweckmäßigerweise sind die Ultraschallschwinger in einer Schwingwanne angeordnet und insbesondere am Boden der Schwingwanne befestigt. Um ein vorgebbares Flüssigkeitsniveau über diesem Boden zu halten, kann ein Sensor, beispielsweise ein Schwimmerschalter, angeordnet werden.

Die Zuführung des Kondenswassers aus der Sammeleinrichtung in die Schwingwanne kann über eine Kondensatleitung mit Hilfe einer Pumpe durchgeführt werden. Es besteht auch die Möglichkeit, die Sammeleinrichtung mit einer Abschrägung in Richtung Schwingwanne und die Schwingwanne mit einer entsprechenden Zulauföffnung zu versehen.

Als Ultraschallschwinger können piezokeramische Schwinger, welche eine Frequenz > 20.000 Hz aufweisen, oder magnetostriktive Schwinger mit einer Frequenz bis 200 Hz eingesetzt werden. Auch handelsübliche Ultraschall-Zerstäuber mit einem piezokeramischen Element, einem Verstärker für die erzeugten mechanischen Schwingungen und einem Zerstäuberteller, auf welchem ein Kondenswasserfilm geringer Schichtdicke zu Kapillarwellen angeregt wird und feinste Tropfen in einer entsprechenden Flugbahn weggeschleudert werden, können eingesetzt werden. Hierbei wird der Flüssigkeitsfilm vorteilhaft durch eine drucklos zugeführte Kondenswassermenge gebildet.

Alternativ kann auch eine Hochdruckpumpe, insbesondere eine Pumpe mit einem Druck > 50 bar zum Zuführen des angefallenen Kondensats zu wenigstens einer Hochdruckdüse, in welcher das Kondensat zu einem sehr feinen Nebel zerstäubt wird, vorgesehen sein. Wenigstens die Hochdruckdüse wird wiederum in den Bereich vor dem Wärmetauscher angeordnet, so dass der feine Kondensatnebel sofort von der trockenen und warmen Abluft aufgenommen und schnell verdunsten kann. Als Hochdruckdüsen können z.B. von der Luftbefeuchtung her bekannte Konstruktionen eingesetzt werden. Durch ein vorteilhaftes Pulsieren der Kondensatströmung können besonders kleine und schnell verdunstende Kondensataerosole gebildet werden.

Die Erfindung wird nachstehend anhand einer Zeichnung weiter erläutert; in dieser zeigen
- Fig. 1: eine stark schematisierte Darstellung eines Schaltschrankes mit einem Ultraschallschwinger als Zerstäubungseinrichtung und
- Fig. 2: eine stark schematisierte Darstellung eines Schaltschrankes mit einer Hochdruckdüse als Zerstäubungseinrichtung.

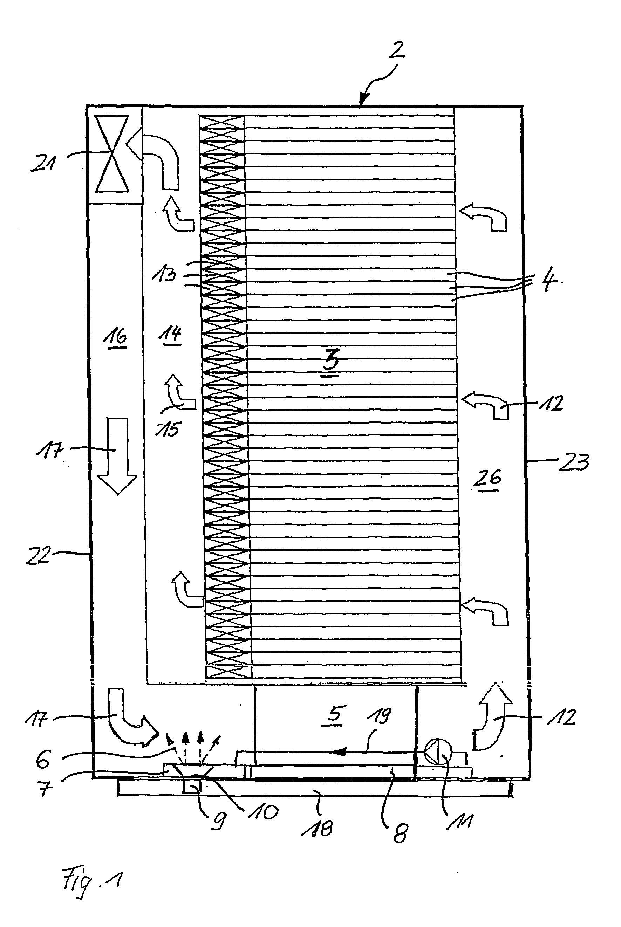

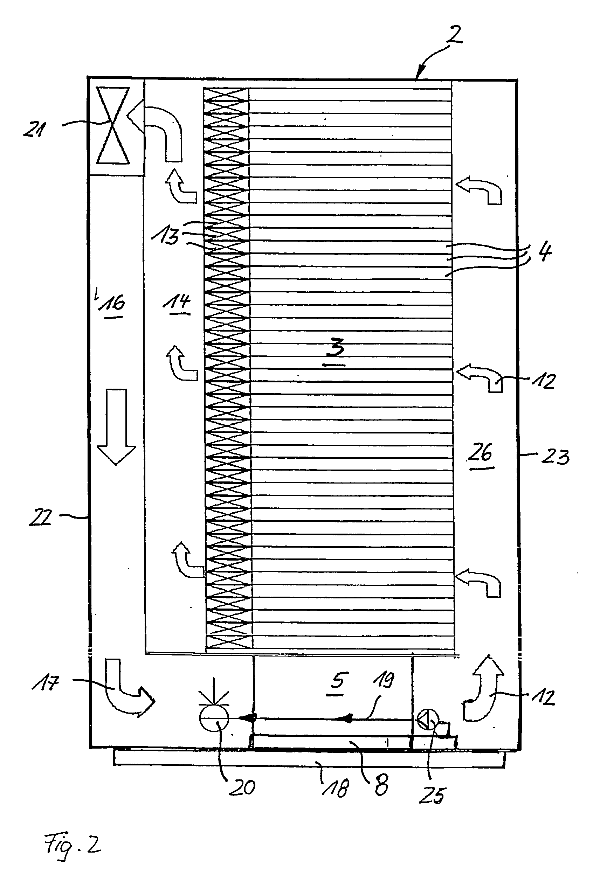

Der Geräteschrank 2 gemäß Fig. 1 und 2 weist einen Innenraum 3 mit übereinander gestapelten elektronischen Moduleinheiten 4 auf. In diesem Beispiel handelt es sich bei den elektrischen Moduleinheiten 4 um Server, welche jeweils in einem Gehäuse mit Luftein- und Luftaustrittsöffnungen (nicht dargestellt) und einem Lüfter 13 aufgenommen sind.

Der Geräteschrank 2 ist weitgehend luftdicht ausgebildet, und die Abführung der Verlustwärme der elektronischen Moduleinheiten 4 erfolgt mit Hilfe eines Wärmetauschers 5, welcher vorteilhaft als Luft-Wasser-Wärmetauscher mit Anschluss des Kühlwassers an die Kaltwasserversorgung des Gebäudes ausgebildet ist.

Der Wärmetauscher 5 ist bodenseitig im Schaltschrank 2 angeordnet, und darin abgekühlte Zuluft 12 wird den einzelnen Moduleinheiten 4 über einen Zuluftkanal 26 im Bereich einer frontseitigen Tür 23 zugeführt. Die Abluftströme der einzelnen elektronischen Moduleinheiten 4 gelangen in einen aufwärts gerichteten Abluftstrom 15 innerhalb eines ersten Abluftkanals 14 und werden mit Hilfe wenigstens eines im Bereich einer rückseitigen Tür 22 angeordneten Ventilators 21 in einen zweiten Abluftkanal 16 umgelenkt. Die abwärts gerichtete Abluftströmung 17 wird dem Wärmetauscher 5 zugeführt.

Unterhalb des Wärmetauschers 5 ist eine Kondensatauffangwanne 8 angeordnet, welche im Ausführungsbeispiel gemäß Fig. 1 über eine Kondensatleitung 19 mit einer Schwingwanne 7 in Verbindung steht.

Die Schwingwanne 7 ist - in Bezug auf den geschlossenen Kühlluftkreislauf - vor dem Wärmetauscher 5, beispielsweise mit annähernd gleichem Niveau wie die Kondensatauffangwanne 8 angeordnet, und mit wenigstens einem Ultraschallschwinger 10 als Zerstäubungseinrichtung versehen. Der Ultraschallschwinger 10 weist einen Hochfrequenzgenerator 9 auf, welcher in den Bereich eines Schranksockels 18 reicht.

Bei Verwendung eines piezokeramischen Ultraschallschwingers 10, welcher am Boden der Schwingwanne 7 angeordnet ist, wird das darüber stehende Kondenswasser durch hochfrequente Wechselspannung in Schwingungen versetzt, und die sich ausbreitenden Ultraschallwellen bewirken die Zerstäubung des Kondenswassers, d.h. die Ablösung kleinster Flüssigkeitströpfchens bzw. Kondenswasseraerosole.

Durch die Anordnung der Zerstäubungseinrichtung 10 mit der Ultraschallschwingwanne 7, im Bereich der Zuführung des warmen, trockenen Abluftstroms 17 zum Wärmetauscher 5 werden die Kondenswasseraerosole aufgenommen und verdunsten adiabatisch. Damit verbunden ist eine Abkühlung, welche sich vorteilhaft auf die erforderliche Kühlleistung des Wärmetauschers 5 auswirkt. Gleichzeitig wird durch die Kondenswasserzerstäubung die erforderliche Luftfeuchtigkeit des Luftstroms im Schaltschrank 2 gewährleistet und die mit einer Entfeuchtung verbundenen Schäden an den eingebauten Moduleinheiten verhindert.

In Fig. 2 ist eine alternative Zerstäubungseinrichtung 20 gezeigt, welche wiederum im Bereich der dem Wärmetauscher 5 zugeführten, warmen und trockenen Abluftströmung 17 angeordnet ist. Die weiteren Merkmale des Schaltschranks 2 sind identisch und weisen deshalb dieselben Bezugszeichen auf.

Als Zerstäubungseinrichtung 20 für das in der Kondensatauffangwanne 8 gesammelte Kondensatwasser ist wenigstens eine Hochdruckdüse 20 angeordnet. Dieser Hochdruckdüse 20 wird das Kondenswasser aus der Auffangwanne 8 mit Hilfe einer Hochdruckpumpe 25 zugeführt.

Es liegt im Rahmen der Erfindung, auch mehrere Hochdruckdüsen 20 vorzusehen.

Außerdem ist die Erfindung nicht auf einen Schalt-, Geräte-oder Netzwerkschrank mit einem bodenseitig angeordneten Wärmetauscher begrenzt, sondern umfasst weitere Kühlgeräte mit Kondenswasseranfall unabhängig von deren Positionierung. Beispielsweise können auch Kühlgeräte mit einem Kältekreislauf, welcher einen Verdampfer, einen Verflüssiger und einen Vedichter aufweist, mit einer Zerstäubungseinrichtung gemäß der Erfindung versehen werden.

## Patentansprüche

1. Schaltschrank
mit einem Innenraum (3) zur Aufnahme von elektronischen Moduleinheiten (4),
einem geschlossenen Kühlluftkreislauf, welcher einen Wärmetauscher (5) zur Abführung der Verlustwärme der
elektronischen Moduleinheiten (4) aufweist, und
mit einer Sammeleinrichtung (8) für das im Wärmetauscher (5) anfallende Kondenswasser,
**dadurch gekennzeichnet ,**
**dass** eine Zerstäubungseinrichtung (10; 20) für das Kondenswasser vorgesehen ist, welche das Kondenswasser in Aerosole (9) überführt,
**dass** die Kondenswasseraerosole (9) zur Stabilisierung der Luftfeuchte im Schaltschrank (2) dem Kühlluftkreislauf zuführbar sind, und
**dass** die Zerstäubungseinrichtung, (10; 20), bezogen auf die Strömungsrichtung des Kühlluftkreislaufes, vor dem Wärmetauscher (5) angeordnet ist und die Kondenswasseraerosole (9) von einem mit der Verlustwärme der elektronischen Moduleinheiten (4) beladenen, warmen und trockenen Abluftstrom (17) aufnehmbar und unter einer adiabaten Abkühlung des Abluftstroms (17) in Wasserdampf überführbar sind.

2. Schaltschrank nach Anspruch 1,
**dadurch gekennzeichnet ,**
**dass** als Zerstäubungseinrichtung wenigstens ein Ultraschallschwinger (10) angeordnet ist.

3. Schaltschrank nach Anspruch 1,
**dadurch gekennzeichnet ,**
**dass** als Zerstäubungseinrichtung wenigstens eine Hochdruckdüse (20) angeordnet ist.

4. Schaltschrank nach einem der vorhergehenden Ansprüche,
**dadurch gekennzeichnet ,**
**dass** als Sammeleinrichtung (8) für das Kondenswasser eine Kondensatauffangwanne unterhalb des Wärmetauschers (5) angeordnet ist und eine Pumpe (11) und eine Kondensatleitung (19) vorgesehen sind, welche eine vorgebbare Kondenswassermenge der Zerstäubungseinrichtung (10; 20) zuführen.

5. Schaltschrank nach einem der vorhergehenden Ansprüche,
**dadurch gekennzeichnet ,**
**dass** eine Schwingwanne (7) für einen Ultraschallschwinger als Zerstäubungseinrichtung (10) vorgesehen ist, in welche das Kondenswasser aus der Sammeleinrichtung (8) einführbar ist.

6. Schaltschrank nach Anspruch 5,
**dadurch gekennzeichnet ,**
**dass** der Schwingwanne (7) das Kondenswasser mit Hilfe einer Abschrägung, beispielsweise eines abgeschrägten Bodens der Sammeleinrichtung (8), zuführbar ist.

7. Schaltschrank nach einem der vorhergehenden Ansprüche,
**dadurch gekennzeichnet ,**
**dass** als Zerstäubungseinrichtung (10) ein piezokeramischer Ultraschaltschwinger mit einer Frequenz > 20.000 Hz oder ein magnetostriktiver Ultraschallschwinger mit einer Frequenz bis 200 Hz eingesetzt ist.

8. Schaltschrank nach einem der vorhergehenden Ansprüche,
**dadurch gekennzeichnet ,**
**dass** eine Hochdruckpumpe (25) angeordnet ist, welche das Kondenswasser mit einem Druck > 50 bar einer Hochdruckdüse als Zerstäubungseinrichtung (20) zuführt.

9. Schaltschrank nach einem der vorhergehenden Ansprüche,
**dadurch gekennzeichnet ,**
**dass** die Zerstäubungseinrichtung (10, 20) in Abhängigkeit von der Luftfeuchtigkeit im Zuluftstrom (12) regulierbar ist.

10. Schaltschrank nach einem der vorhergehenden Ansprüche,
**dadurch gekennzeichnet ,**
**dass** eine Überlaufeinrichtung in der Sammeleinrichtung (8) angeordnet ist.

11. Schaltschrank nach einem der vorhergehenden Ansprüche,
**dadurch gekennzeichnet ,**
**dass** als Wärmetauscher (5) ein Luft-Wasser-Wärmetauscher im bodenseitigen Bereich des Schaltschrankes (2) angeordnet ist.

## Claims

1. Switch cabinet
having an inner area (3) for receiving electronic modular units (4),
a closed cooling air circuit, which has a heat exchanger (5) for dissipating the heat loss of the electronic modular units (4), and
with a collecting device (8) for the condensate produced in heat exchanger (5),
**characterized in that**
an atomizing device (10; 20) for the condensate is provided which transforms the condensate into aerosols (9),
the condensate aerosols (9) can be supplied to the cooling air circuit for stabilizing the atmospheric humidity in the switch cabinet (2), and
the atomizing device (10; 20), relative to the flow direction of the cooling air circuit, is positioned upstream of the heat exchanger (5) and the condensate aerosols (9) can be received by hot, dry exhaust air flow (17) subject to the heat loss of the electronic modular units (4) and can be transformed into water vapour accompanied by an adiabatic cooling of the exhaust air flow (17).

2. Switch cabinet according to claim 1,
**characterized in that**
at least one ultrasonic vibrator (10) is provided as atomizing device.

3. Switch cabinet according to claim 1,
**characterized in that**
at least one high pressure nozzle (20) is provided as atomizing device.

4. Switch cabinet according to one of the preceding claims,
**characterized in that**
as collecting device (8) for the condensate a condensate collecting tank is placed below the heat exchanger (5) and a pump (11) and a condensate line (19) are provided, which supply a predeterminable condensate quantity to atomizing device (10; 20).

5. Switch cabinet according to one of the preceding claims,
**characterized in that**
a vibrating tank (7) is provided for an ultrasonic vibrator as the atomizing device (10) and into which the condensate can be introduced from the collecting device (8).

6. Switch cabinet according to claim 5,
**characterized in that**
the condensate can be supplied to the vibrating tank (7) with the aid of a bevel, e.g. a bevelled bottom of collecting device (8).

7. Switch cabinet according to one of the preceding claims,
**characterized in that**
a piezoceramic ultrasonic vibrator with a frequency >20,000 Hz or a magnetostrictive ultrasonic vibrator with a frequency up to 200 Hz is used as atomizing device (10).

8. Switch cabinet according to one of the preceding claims,
**characterized in that**
a high pressure pump (25) is provided, which supplies condensate at a pressure >50 bar to a high pressure nozzle as atomizing device (20).

9. Switch cabinet according to one of the preceding claims,
**characterized in that**
the atomizing device (10; 20) can be regulated as a function of the atmospheric humidity in the supply air flow (12).

10. Switch cabinet according to one of the preceding claims,
**characterized in that**
an overflow device is provided in the collecting device (8).

11. Switch cabinet according to one of the preceding claims,
**characterized in that**
as heat exchanger (5) is provided an air-water heat exchanger in the bottom area of the switch cabinet (2).

## Revendications

1. Armoire de commande comportant un volume intérieur (3) recevant des modules électroniques (4),
un circuit d'air de refroidissement, fermé, ayant un échangeur de chaleur (5) pour évacuer la chaleur dégagée par les modules électroniques (4) et
une installation collectrice (8) pour l'eau de condensation produite par l'échangeur de chaleur (5),
**caractérisée par**
une installation de pulvérisation (10, 20) pour l'eau de condensation qui transforme cette eau en aérosols (9),
les aérosols de l'eau de condensation (9) sont fournis au circuit d'air de refroidissement pour stabiliser l'humidité de l'air dans l'armoire de commande (2) et
l'installation de pulvérisation (10, 20) est située en amont de l'échangeur de chaleur (5) selon le sens de passage du circuit d'air de refroidissement et les aérosols d'eau de condensation (9) sont reçus par un chaud et sec courant d'air de sortie. (17), chargé avec la chaleur degagée par les modules électroniques (4), et sont transformés en vapeur d'eau, le transfert se faisant avec un refroidissement adiabatique du courant d'air de sortie (17).

2. Armoire de commande selon la revendication 1,
**caractérisée en ce que**
l'installation de pulvérisation est constituée par au moins un oscillateur à ultrasons (10).

3. Armoire de commande selon la revendication 1,
**caractérisée en ce que**
l'installation de pulvérisation est constituée par au moins une buse à haute pression (20).

4. Armoire de commande selon l'une des revendications précédentes,
**caractérisée en ce que**
l'installation collectrice (8) pour l'eau de condensation comporte une cuvette de réception de condensats sous l'échangeur de chaleur (5) et une pompe (11) ainsi qu'une conduite de condensats (19) fournissant une quantité prédéfinie d'eau de condensation à l'installation de pulvérisation (10 ; 20).

5. Armoire de commande selon l'une des revendications précédentes,
**caractérisée par**
une cuvette oscillante (7) pour un oscillateur à ultrasons comme installation de pulvérisation (10) qui reçoit l'eau de condensation de l'installation collectrice (8).

6. Armoire de commande selon la revendication 5,
**caractérisée en ce que**
la cuvette oscillante (7) reçoit l'eau de condensation par l'intermédiaire d'une pente, par exemple par le fond incliné de l'installation collectrice (8).

7. Armoire de commande selon l'une des revendications précédentes,
**caractérisée en ce que**
l'installation de pulvérisation (10) comporte un oscillateur à ultrasons à céramique piézo-électrique fonctionnant à une fréquence supérieure à 20.000 Hz ou un oscillateur à ultrasons magnétostrictif fonctionnant avec une fréquence allant jusqu'à 200 Hz.

8. Armoire de commande selon l'une quelconque des revendications précédentes,
**caractérisée par**
une pompe haute pression (25) qui fournit l'eau de condensation à une pression supérieure à 50 bars à une buse de haute pression comme installation de pulvérisation (20).

9. Armoire de commande selon l'une des revendications précédentes,
**caractérisée en ce que**
l'installation de pulvérisation (10, 20) est réglée en fonction de l'humidité de l'air de la veine d'air (12).

10. Armoire de commande selon l'une quelconque des revendications précédentes,
**caractérisée par**
une installation de débordement dans l'installation collectrice (8).

11. Armoire de commande selon l'une quelconque des revendications précédentes,
**caractérisée en ce que**
l'échangeur de chaleur (5) est un échangeur de chaleur air-eau installé au niveau du fond de l'armoire de commande (2).
